Europäisches Patentamt

(19) European Patent Office

Office européen des brevets

(11) EP 0 860 949 A1

(12) EUROPEAN PATENT APPLICATION

(43) Date of publication:
26.08.1998 Bulletin 1998/35

(51) Int. Cl.$^6$: H03K 23/50

(21) Application number: 97410019.0

(22) Date of filing: 19.02.1997

(84) Designated Contracting States:
DE FR GB

(71) Applicant:
Hewlett-Packard Company
Palo Alto, California 94304 (US)

(72) Inventor: Brebner, Gavin
38410 St Martin D'Uriage (FR)

(74) Representative:
Squibbs, Robert Francis
Intellectual Property Section,
Legal Department,
Hewlett-Packard France,
Etablissement de Grenoble
38053 Grenoble Cédex 9 (FR)

(54) Synchronous binary counter

(57) A synchronous binary counter (30) has a plurality of stages (20A,20B), each with a number of synchrounously clocked flipflops (21 to 23) and combinational logic (24 to 26) for determining the states of these flipflops following their next clocking. Each stage (20B), other than the first, receives a carry signal from a preceding stage (20A). In order to avoid the carry signals passed to later stages (20B) being subject to excessive ripple-through delays in the combinatinal logic (24A, 25A, 26A) in the preceding stages (20A), the carry signal passed from one stage to another is delayed by a delayed-carry circuit (31) such that it is input to the receiving stage (20B) at the start of the clock period following that in which it was generated by the outputting stage (20A). This enables any number of counter stages to be serially interconnected without problems caused by signal delay in the combinational logic.

FIG. 4

EP 0 860 949 A1

## Description

### Field of the Invention

The present invention relates to synchronous binary counters and dividers. As will be well understood by persons skilled in the art, the basic circuitry of a synchronous binary counter is the same as for a synchronous binary divider. Accordingly, for convenience the term "counter" will be used herein also to cover dividers except in relation to specific usages where the term "divider" is more natural. The term "counter" is therefore to be read as covering dividers unless the context otherwise requires.

### Background of the Invention

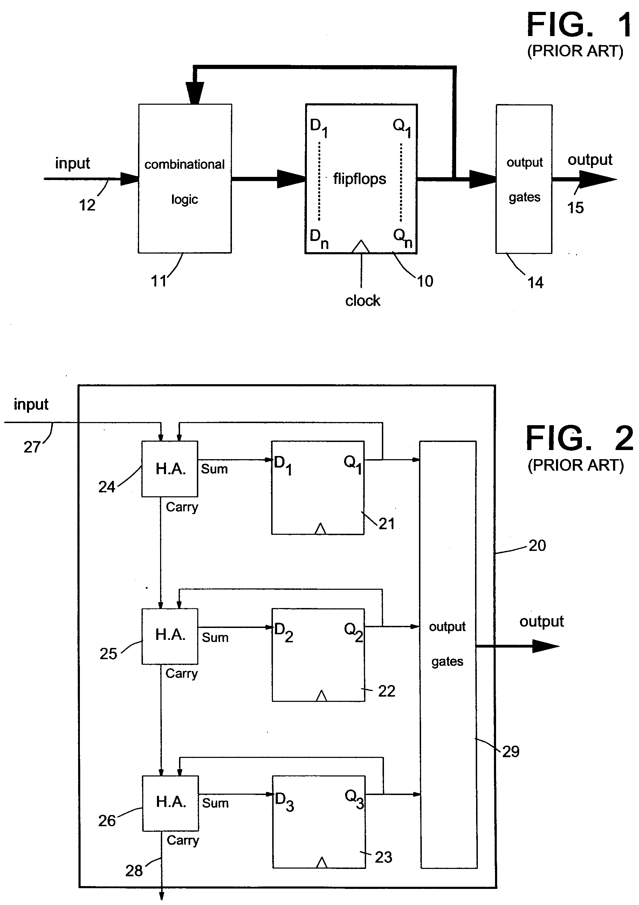

Figure 1 illustrates the general form of a synchronous binary system. A set of n synchronously clocked flipflops 10 have their next states determined by combinational logic 11 in dependence on the output states $Q_1$ to $Q_n$ of the flipflops 10 and inputs 12, the combinational logic setting these next states on the D inputs $D_1$ to $D_n$ of the flipflops. At each clocking of the flipflops 10, the states present at the D inputs of these flipflops are transferred to their outputs Q. The flipflop outputs $Q_1$ to $Q_n$ are also used by output gates 14 to determine the output 15 of the system. A requirement of such an arrangement is that the combinational logic has sufficient time between clock pulses to settle and produce the next-state signals on the D inputs of the flipflops 10.

A common usage of synchronous binary systems is to provide counters in a whole range of applications including counting external events, counting clock pulses to provide cyclic count outputs (in which case the counter acts as a timer), and dividing down clock signals. In fact, the same counter may be used to provide more than one function at the same - thus, in many complex computer subsystems a synchronous binary counter may serve to provide both a clock division function and to provide cyclic trigger signals at specific clock counts.

Figure 2 shows the form of a simple three-bit synchronously-clocked arithemetic counter 20. In this example, the flipflops 10 of the Figure 1 system are provided by flipflops 21, 22 and 23 of increasing binary significance; more particularly, the output $Q_1$ of flipflop 21 has a binary weighting of $2^0$, the output $Q_2$ of flipflop 22 has a binary weighting of $2^1$ and the output $Q_3$ has a binary weighting of $2^2$. The combinational logic 11 of the Figure 1 system is provided in the Figure 2 counter by three half adders 24, 25, 26 respectively associated with flipflops 21, 22 and 23. Each half adder has two inputs and sum and carry ouputs, and may be constituted by an OR gate and an AND gate as is well understood by persons skilled in the art. Each half adder 24, 25, 26 has one input connected to the Q output of its associated flipflop 21, 22, 23 and its sum input connected to the D input of the same flipflip. Half adder 24 has its second input connected to an input 27 of the counter 20. The carry outputs of half adders 24, and 25 are respectively connected to the second inputs of half adders 25 and 36 whilst the carry output of half adder 26 forms a carry output 28 of the counter 20.

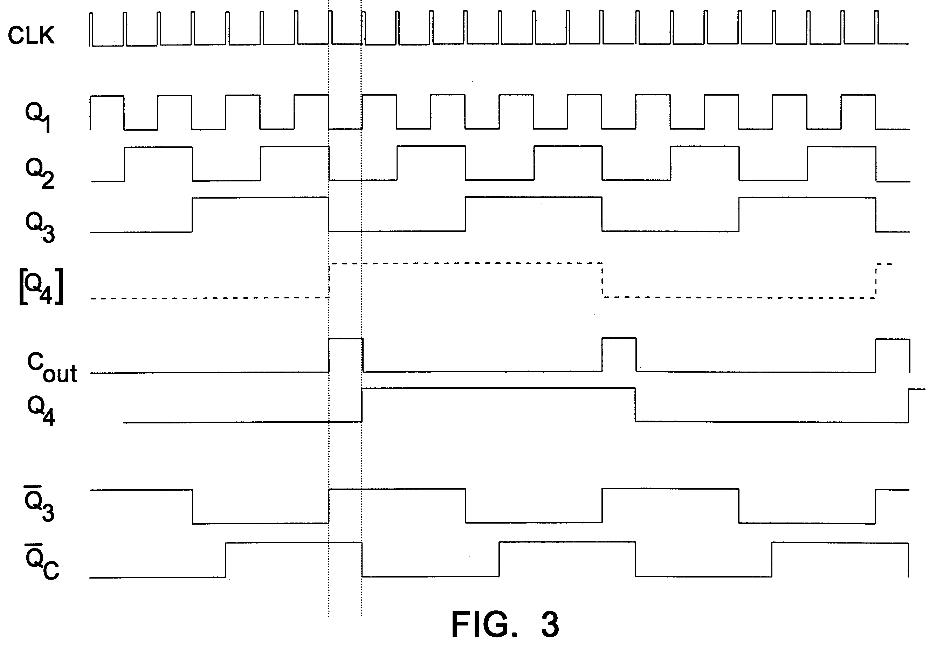

For each clock period that the counter input is high, the count represented by the outputs of flipflops 21, 22, 23 will be increased by one at the following clocking of these flipflops. Output gates 29 decode the outputs of the flipflops to provide outputs at desired count values. By setting input 27 permanently high, the counter is incremented every clock cycle and can be used to provide divided down clock signals from the outputs of the flipflops. Figure 3 illustrates various waveforms for the Figure 2 counter when operated in this manner. More particularly, the clocking signal used to clock all three flipflops is represented by waveform CLK whilst the outputs of the flipflops 21, 22 and 23 are respectively represented by the waveforms labelled $Q_1$, $Q_2$ and $Q_3$.

In practice, counters usually have more flipflops (for example, eight flipflops for a eight bit counter) and are often provided in a form facilitating their serial interconnection through the connection of the carry output of one counter (or counter stage) to the count input of the next counter stage; in this manner, any desired length of counter can be provided.

However, because the next state of the final flipflop of a synchronous counter may depend on the current state of all the other flipflops as well as on the counter input state, there can be a significant delay following the clocking of the flipflops before all the necessary signal states have rippled through the combinational logic to determine the next state of the final counter stage. This delay places a limit on the number of flipflop stages that can be provided in the counter since this delay must obviously be less than the clock period if the counter is to operate correctly.

Unfortunately, as the clock speeds in modern processors increase, not only is the time available for the signals to ripple through the combinational logic reduced, but there is also generally a need to provide extra flipflop stages in order to reduce the clock frequency to that usuable by lower-speed subsystems.

The ripple through delay in the combinational logic can be reduced by the use of look-ahead carry circuits but there is a practical limit as to how complex and extensive such circuits can be made. This generally leads to solutions where the combinational logic includes look ahead carry circuits arranged in series; whilst such solutions give substantial reductions in ripple through times, they still result in these times increasing with the number of flipflop stages so that again there is a limit on the number of flipflop stages that are possible.

It is an object of the present invention to provide a simple practical solution for dealing with the problem noted above.

## Summary of the Invention

According to the present invention, there is provided a synchronous binary counter comprising:

-- first and second stages each having a plurality of clocked flipflops, and combinational logic for determining the states of the flipflops at their next clocking; the flipflops of both stages being synchronously clocked from a common clocking signal, and
-- delayed-carry means connected between an output of a predetermined one of the first-stage flipflops and the second stage, and serving to provide a carry signal for substantially all of the clock period following on a clocking of the flipflops that results in the predetermined flipflop changing state, this carry signal being provided to the second-stage combinational logic to cause the latter to change the state of at least one of the second-stage flipflops at their next clocking.

Thus whereas normally a carry signal would be output from the first-stage combinational logic to the second stage at the same time as the combinational logic generates the sum signal determinng a change in state of the predetermined flipflop (generally the most significant flipflop of the first stage), in the present form of counter, the second stage is provided with a carry signal in the following clocking period, this carry signal being generated from the output of the predetermined flipflop. The operation of the second stage may therefore be viewed as delayed by a clock period relative to that of the first stage.

In one embodiment, the delayed-carry means provides the carry signal for substantially all of the clock period following on each of only those clockings of the flipflops that result in the predetermined flipflop changing to a particular one of its two possible states. In another embodiment, the delayed-carry means provides the carry signal for substantially all of the clock period following on every clocking of the flipflops that result in the predetermined flipflop changing state; in this case, the least significant flipflop of the second stage will generally reproduce the operation of the predetermined flipflop of the first stage.

According to another aspect of the invention, there is provided a synchronous binary counter comprising:

-- first and second stages each having a plurality of clocked flipflops, and combinational logic for determining the states of the flipflops at their next clocking; the flipflops of both stages being synchronously clocked from a common clocking signal, and the first-stage combinational logic including carry-indication means for producing a carry indication, this carry indication being significantly delayed relative to the start of the clock period in which it is produced; and

-- delayed-carry means connected to receive the carry indication and serving to provide a carry signal for substantially all of the clock period following that in which the carry indication is produced, this carry signal being provided to the second-stage combinational logic to cause the latter to change the state of at least one of the second-stage flipflops at their next clocking.

This form of counter also effectively delays operation of the second stage relative to the first stage by a clock period. However, in this form of the counter, the carry signal is derived by delaying the carry indication normally produced by the first-stage combinational logic. Preferably, the delayed-carry means comprises a synchronously-clocked flipflop into which the carry indication is clocked at the clocking following its appearance, the carry signal being provided from an output of this flipflop.

Whichever form of binary counter of the invention is used, the counter may comprise at least one further said stage each with a respective plurality of synchronously-clocked flipflips and combinational logic, and each having an associated delayed-carry means connecting the stage to another one of the stages, the stages being overall connected into a series possibly with one or more branches each of one or more stages.

Where the counter serves to provide particular count indications, the counter may further comprise output decoding circuitry connected to receive as input the output of at least one flipflop in each stage either directly or through combinational decoding logic associated with the corresponding stage, and delay means for delaying by appropriate numbers of clock periods the inputs to the output decoding circuitry coming from stages other than the most significant stage connected to the decoding circuitry. This delaying of some of the decoding-circuitry inputs compensates for the fact that the more significant counter stages are operating with succcessively increasing delays as a result of the carry signals being delayed.

In one arrangement, the first-stage combinational logic is configured such that the state of at least one of the first-stage flipflops changes at each clocking whereby to count/divide down the clocking signal.

In another arrangement, the first stage has associated input means for receiving an alternating-state input signal and providing a count signal for substantially all of the clock period following a change in state of this input signal, the count signal being provided to the first-stage combinational logic to cause at least one of the first-stage flipflops to change state at the next clocking of the flipflops, the input means being of substantially the same form as the delayed-carry means. This arrangement is advantageous as now each stage and its associated input circuit (input means / delayed-carry means) can be of substantially the same form. The arrangement can also be used to count/divide the clocking signal by deriving the alternating-state signal from the clocking signal (for example, by a toggle flipflop).

As already indicated, the counter of the invention can be used both as a frequency divider, for example, for dividing down the clocking signal, and as a counter, for example for providing cyclic counts from the clocking signal.

## Brief Description of the Drawings

Embodiments of the invention will now be described, by way of non-limiting example, with reference to the accompanying diagrammatic drawings, in which:

. **Figure 1**    is a diagram illustrating the general form of a synchronous binary system;

. **Figure 2**    is a diagram of a three-bit synchronous binary counter of standard form;

. **Figure 3**    is a diagram illustrating various signals present in one or more of the counters of Figure 2, 4 and 5;

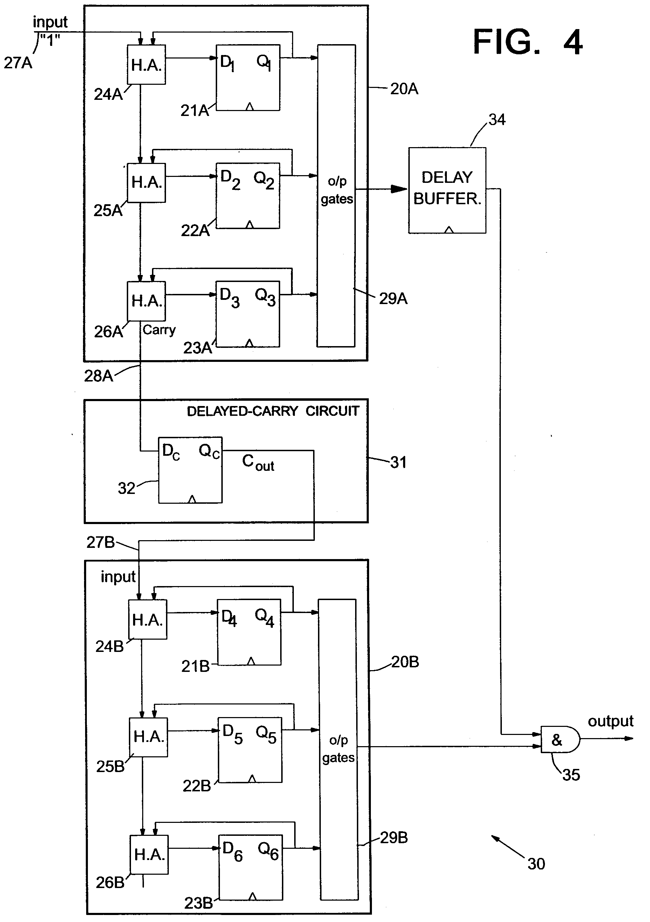

. **Figure 4**    is a diagram of a first counter embodying the invention in which two three-bit counter stages are interconnected by a first form of delayed-carry circuit;

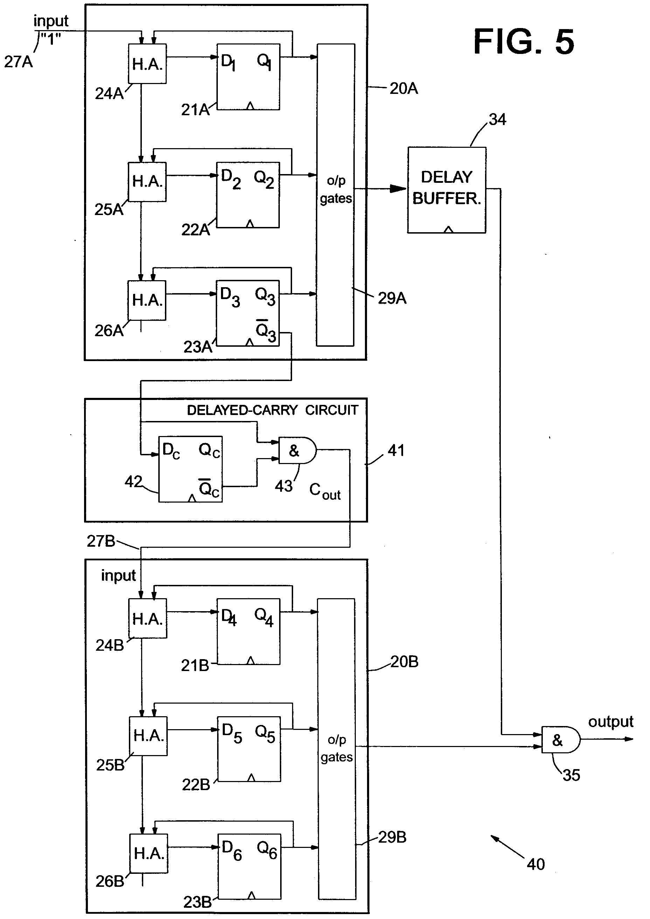

. **Figure 5**    is a diagram of a second counter embodying the invention in which two three-bit counter stages are interconnected by a second form of delayed-carry circuit;

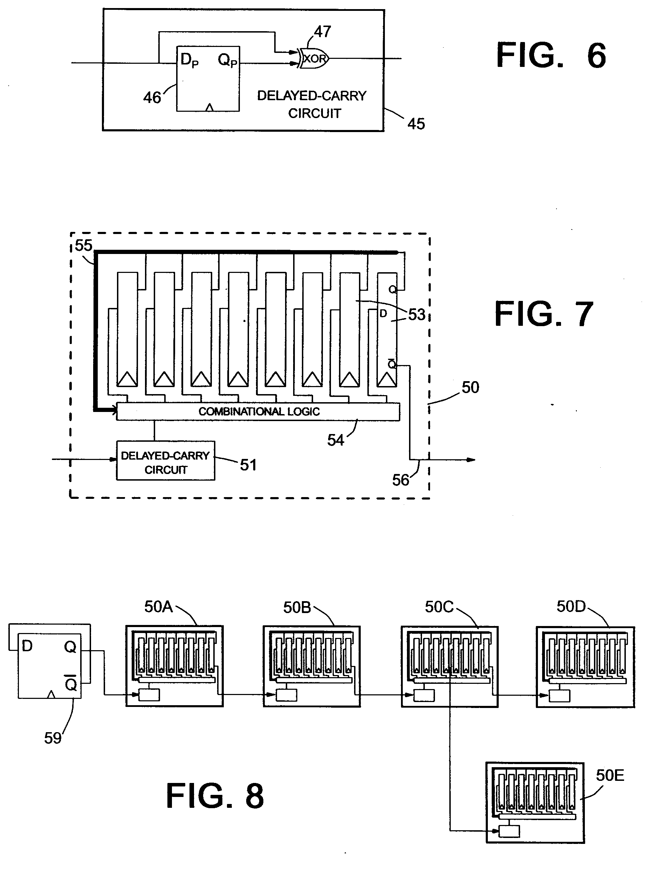

. **Figure 6**    is a diagram of a third form of delayed-carry circuit for use in a further embodiment of the present invention;

. **Figure 7**    is a diagram of a repeatable counter unit made up of an eight-bit counter stage and an associated delayed-carry ciruit; and

. **Figure 8**    is a diagram of a third counter embodying the invention in which five counter units of the Figure 7 form are interconnected into a main series with one side branch.

## Best Mode of Carrying Out the Invention

Figure 4 shows a first embodiment of the invention in which a six-bit synchronous counter 30 is formed by the interconnection of two three-bit synchronous counter stages 20A and 20B each having the same form as the Figure 2 counter 20. The various elements of the counter stages 20A and 20B have been given the same references as the corresponding elements in Figure 2 but with the addition of 'A' or 'B' as appropriate.

The flipflops 21A, 22A, 23A and 21B, 22B, 23B of the two counter stages 20A and 20B are synchronously clocked by the same clocking signal CLK. The flipflops 21A, 22A and 23A effectively from the first, second and third flipflop stages respectively of counter 30 whilst the flipflops 21B, 22B and 23B from the fourth, fifth and sixth flipflop stages of the counter 30; the D inputs and Q outputs of the flipflops have been suffixed to indicate the ranking of the corresponding flipflop stage.

The input 27A of the first counter stage 20A is tied to logic "1" whereby the counter stage 20A increments each clock cycle. The carry output 28A of counter stage 20A is connected via a delayed-carry circuit 31 to the input 27B of counter stage 20B. The delayed-carry circuit 31 is formed by a D-type flipflop 32 whose input $D_C$ is connected to output 28A of counter stage 20A and whose output $Q_C$ is connected to input 27B of counter stage 20B. Flipflop 32 is synchronously clocked with the flipflops of the counter stages 20A, 20B. Flipflop 32 serves to delay the transmission, to input 27B, of a carry signal produced by half-adder 26A until the clock cycle following that in which the carry signal first appears. Counter stage 20B thus operates one clock cycle in arrears of what would be the case if the carry output 28A of counter stage 20A had been directly connected to input 27B. This is illustrated in Figure 3 where dashed waveform [Q4] represents the output that would have been produced by flipflop 21B with carry output 28A directly connected to input 27B, and waveform Q4 represents the output of flipflop 21B with the delayed-carry circuit interposed between carry output 28A and input 27B. Waveform $C_{out}$ represents the delayed carry signal fed to the input 27B.

The provision of the delayed-carry circuit 31 means that even if the carry output from half-adder 26A is not produced until close to the end of a clock cycle (as may occur if the clock rate is high relative to the propagation speed through the half adders), incorrect operation of counter stage 20B does not result because the carry signal is synchronised to the system clock by circuit 31 for input to counter stage 20B.

The one-lock-period delay in operation between counter stages 20A and 20B does, however, also mean that the outputs of the two groups of flipflops 21A, 22A, 23A and 21B, 22B, 23B cannot be given their usual interpretations when read at the same time because in the clock period following a number X of clock pulses, the flipflops of counter stage 20A will have counted these X clock pulses (modulo 8) whereas counter stage 20B will have only felt the effect of (X-1) clock pulses on stage 20A. This discrepancy can be handled either by non standard decoding of the outputs of the flipflops or by delaying the influence of the output of flipflops 21A, 22A, 23A on the count to be decoded relative to the influence of flipflops 21B, 22B and 23B. This delaying can be done either by delaying the output of each flipflop 21A, 22A, 23A by one clock cycle prior to passing their outputs to count decoding logic, or by first carrying out partial decodes on the outputs of the two groups of flipflops 21A, 22A, 23A and 21B, 22B, 23B, and then delaying the partial decode from flips 21A, 22A, 23A by one clock period before combining the partial decodes from the two groups of flipflops to give the required count decode. This latter arrangement is illustrated in Figure 4 where the ouput gates 29A and 29B effect partial decodes from their corresponding groups of flipflops, the output from gates 29A then being delayed for one clock period by delay buffer 34 (for example, similar in form to circuit 31) before being combined with the partial decode from gates 29B in AND gate 35.

Where the counter 30 is used to effect clock frequency division, then the delay introduced by the circuit 31 will generally not be relevant and the desired divided-down frequency can be taken from the appropriate flipflop output.

It will be appreciated that the counter 30 may be provided with further counter stages each similar to counter stage 20B and each receiving a delayed carry signal from a preceding counter stage by means of a respective delayed-carry circuit 31 connected between the carry output of that preceding stage and the count input of the stage concerned. In this case, where a count decode is to be carried out spanning several counter stages, the partial decode from each counter stage involved in the count decode, other than the most significant one of these stage (stage 20B in Figure 4), must be delayed by a number of clock periods equal to the number of delayed-carry circuits 31 between the stage concerned and the most significant stage involved in the count decode.

It will also be appreciated that the number of flipflop stages in each counter stage may be different from that illustrated in Figure 4 and not necessarily the same for each stage.

Figure 5 shows a second embodiment of the invention in the form of a counter 40 similar to counter 30 of Figure 4 but with a different form of delayed-carry circuit. For clarity, the same references are used for the same elements in counters 30 and 40.

In counter 40, the delayed-carry circuit 41 works off an output $\overline{Q}_3$ of the most significant flipflop 23A of counter stage 20A. The delayed-carry circuit 41 comprises a D-type flipflop 42 synchronously clocked with the flipflops of counter stages 20A and 20B, and an AND gate 43. The input $D_C$ of flipflop 42 is connected to the output $\overline{Q}_3$ of flipflop 23A whilst the output $\overline{Q}_C$ of flipflop 42 is connected to one input of AND gate 43. A second input of gate 43 is also connected to output $\overline{Q}_3$ of flipflop 23A whilst whilst the output of flipflop 42 is connected to the input 27B of counter stage 20B. Flipflop 42 clocks in the value on output $\overline{Q}_3$ of flipflop 23A at every clock pulse; however, as any change in $\overline{Q}_3$ takes place upon a clocking of flipflop 23A this change will be present for substantially a full clock period before being clocked into flipflop 42; flipflop 42 thus serves to delay the output $\overline{Q}_3$ by one clock period and also to invert it (on output $\overline{Q}_C$). The waveforms appearing at outputs $\overline{Q}_3$ and $\overline{Q}_C$ are illustrated in Figure 3 and, as can be seen, waveform $\overline{Q}_C$ is an inverted form of waveform $\overline{Q}_3$ delayed by one clock period.

The waveforms appearing at $\overline{Q}_3$ and $\overline{Q}_C$ will thus overlap in a "1" state for one clock period each cycle of operation of flipflop 23A and are used by AND gate 43 to produce a delayed carry signal $C_{out}$ of substantially the same form and timing as produced by the delayed-carry circuit 31 of the Figure 4 counter. The signal $C_{out}$ produced by the delayed-carry circuit 41 is used to trigger counter stage 20B which operates in the same manner as already described with respect to counter 30.

The process of count decoding for counter 40 can also be effected in the same manner as for counter 30 and the variants described with respect to that counter (number of counter stages, flipflops in each stage, count decoding across several stages) apply also to counter 40.

Figure 6 shows a further form of delayed-carry circuit 45 which like that of Figure 5 takes its input from an output (either Q or $\overline{Q}$) of the most significant flipflop of the preceding counter stage (for example flipflop 23A). The delayed-carry circuit 45 produces a delayed carry signal of one clock period duration at each transition of the flipflop 23A, that is at twice the frequency of the $C_{out}$ signal produced by the delayed-carry circuit 41. The delayed-carry circuit 45 comprises a D-type flipflop 46 synchronously clocked with the flipflops of the counter stages, and an XOR gate 47; the operation of circuit 45 will be apparent to persons skilled in the art. Use of the delayed-carry circuit 45 results in the least significant flipflop of the following counter stage toggling at the same frequency as the most significant flipflop of the preceding stage but with a delay of one clock period relative thereto.

Whatever the form of the delayed-carry circuit, it is convenient to consider each counter stage and its associated input delayed-carry circuit as a counter building block. Such a building block 50 is illustrated in Figure 7 for the case of a counter stage with eight synchronously clocked flipflops 53 and a delayed-carry circuit 51 of the form shown in Figure 5 or Figure 6. The delayed-carry circuit 51 feeds a delayed-carry signal to the combinational logic 54 of the building block 50. The combinational logic is also connected to the Q inputs and D inputs of the flipflops 53. The inverted output $\overline{Q}$ of the most significant flipflop 53 is made available at output 56 for connection to the input of the delayed-carry circuit of the next counter building block 50. The building block 50 may or may not be provided with count decoding logic; if no such logic is provided, the Q outputs of the flipflops 53 are made externally available.

Where the delayed-carry circuit 51 of the building block 50 has the form illustrated in Figure 5, the building block 50 serves as an 8-bit counter. However, if the delayed-carry circuit is of the Figure 6 form, the Figure 7 building block effectively only provides an additional 7-bit counter as the first flipflop stage transitions at the same frequency as the most significant flipflop of a preceding stage. Accordingly, where the Figure 6 delayed-carry circuit is used, the building block 50 is preferably provided with nine flipflops 53 to give an 8-bit counter stage.

Figure 8 illustrates a counter made up of the interconnection of five building blocks 50A to 50E of the Figure 7 form to form one main series of four serially interconnected counter stages (blocks 50A-50D) with one side branch (block 50E). The delayed-carry circuit of each building block is of the Figure 5 form whereby each building block serves as an 8-bit counter. Considering first the main series, this provides a 32-bit counter with one clock period delays between each successive counter stage. The input to the first counter building block 50A is provided by the Q output of a toggling D-type flipflop 59 that is synchronously clocked with the counter flipflops. As a result, the counter is incremented at half the clock frequency.

Generally, where a clock counter is used to provide cyclic counts (that is, to serve as a timer operating cyclicly), only a limited precision is required. The counter stages of the main series can directly provide a large variety of counts, based on powers of 2, of various precisions without crossing the boundary between counter stages and therefore without the need to compensate for the delay between stages. However, where a count is required of, for example, 8 bit precision relating to a power of 2 occuring midway along a counter stage, then the relevant counter flipflops are spread across two counter stages and the delay between these stages needs to be taken into account. Rather than using a delay buffer 34 such as previously described to delay partial count decodes, an alternative approach can be used. In this case, a further counter building block (see block 50E) is provided as a side branch from the main series, this branch counter stage being tapped off the main series at the appropriate flipflop (here, the fourth flipflop of counter stage 50C). The counter stage of block 50E then provides all the precision bits required.

It will be appreciated that many variants are possible to the above-described embodiments of the present invention. For example, the details of the delayed-carry circuitry can be varied from that shown. Furthermore, the synchronously-clocked counter need not be a simple arithmetic counter but can have any form suitable for its intended application.

**Claims**

1.  A synchronous binary counter comprising:

    -- first and second stages each having a plurality of clocked flipflops, and combinational logic for determining the states of said flipflops at their next clocking; the flipflops of both stages being synchronously clocked from a common clocking signal, and
    -- delayed-carry means connected between an output of a predetermined one of the first-stage flipflops and the second stage, and serving to provide a carry signal for substantially all of the clock period following on a clocking of said flipflops that results in said predetermined flipflop changing state, this carry signal being provided to the second-stage combinational logic to cause the latter to change the state of at least one of the second-stage flipflops at their next clocking.

2.  A counter according to claim 1, wherein said delayed-carry means provides said carry signal for substantially all of the clock period following on each of only those clockings of said flipflops that result in said predetermined flipflop changing to a particular one of its two possible states.

3.  A counter according to claim 1, wherein said delayed-carry means provides said carry signal for substantially all of the clock period following on every clocking of said flipflops that result in said predetermined flipflop changing state.

4.  A counter according to claim 1, wherein said predetermined flipflop is the most-significant flipflop of the first stage.

5.  A synchronous binary counter comprising:

    -- first and second stages each having a plurality of clocked flipflops, and combinational logic for determining the states of said flipflops at their next clocking; the flipflops of both stages being synchronously clocked from a common clocking signal, and the first-stage combinational logic including carry-indication means for producing a carry indication, this carry indication being significantly delayed relative to the start of the clock period in which it is produced; and
    -- delayed-carry means connected to receive said carry indication and serving to provide a carry signal for substantially all of the clock period following that in which said carry indication is produced, this carry signal being provided to the second-stage combinational logic to cause the latter to change the state of at least one of the second-stage flipflops at their next clocking.

6.  A counter according to claim 5, wherein said delayed-carry means comprises a synchronously-clocked flipflop into which said carry indication is clocked at the clocking following its appearance, said carry signal being provided from an output of this flipflop.

7.  A counter according to claim 1 or claim 5, comprising at least one further said stage each with a respective plurality of synchronously-clocked flipflips and combinational logic, and each having an associated said delayed-carry means connecting said stage to another one of said stages, said stages being overall connected into one series by said delayed-carry means.

8. A counter according to claim 1 or claim 5, comprising at least one further said stage each with a respective plurality of synchronously-clocked flipflips and combinational logic, and each having an associated said delayed-carry means connecting said stage to another one of said stages, said stages being overall connected into one main series and at least one side branch of at least one said stage.

9. A counter according to claim 1 or claim 5, further comprising output decoding circuitry connected to receive as input the output of at least one flipflop in each said stage either directly or through combinational decoding logic associated with the corresponding stage, and delay means for delaying by one clock period the said input to said output decoding circuitry coming from said first stage.

10. A counter according to claim 1 or claim 5, wherein the first-stage combinational logic is configured such that the state of at least one of the first-stage flipflops changes at each clocking whereby to count/divide down the clocking signal.

11. A counter according to claim 1 or claim 5, wherein the first stage has associated input means for receiving an alternating-state input signal and providing a count signal for substantially all of the clock period following a change in state of said input signal, this count signal being provided to the first-stage combinational logic to cause at least one of the first-stage flipflops to change state at the next clocking of the flipflops, said input means being of substantially the same form as said delayed-carry means.

12. A counter according to claim 11, further comprising means for deriving said alternating-state signal from the clocking signal.

13. A system including a counter according to claim 1 or claim 5, wherein the counter is used as a frequency divider for dividing down the clocking signal.

14. A system including a counter according to claim 1 or claim 5, wherein the counter is used to provide cyclic counts from the clocking signal.

FIG. 1
(PRIOR ART)

input 12 → combinational logic 11 → flipflops 10 ($D_1$ ... $D_n$, $Q_1$ ... $Q_n$, clock) → output gates 14 → output 15

FIG. 2
(PRIOR ART)

input 27, H.A. 24, 25, 26 (Sum, Carry), $D_1$ $Q_1$ 21, $D_2$ $Q_2$ 22, $D_3$ $Q_3$ 23, output gates 29, output, 20, 28

FIG. 3

EP 0 860 949 A1

FIG. 4

FIG. 5

FIG. 6

FIG. 7

FIG. 8

**European Patent Office**

**EUROPEAN SEARCH REPORT**

Application Number

EP 97 41 0019

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | PATENT ABSTRACTS OF JAPAN vol. 010, no. 386 (E-467), 24 December 1986 & JP 61 176213 A (TOSHIBA CORP;OTHERS: 01), 7 August 1986, * abstract * | 1-7,9-14 | H03K23/50 |
| X | JP 61 176 213 A (TOSHIBA CORP;OTHERS: 01) 7 August 1986 * figures 1,2 * | 1-7,9-14 | |
| X | PATENT ABSTRACTS OF JAPAN vol. 010, no. 251 (E-432), 28 August 1986 & JP 61 079322 A (TOSHIBA CORP;OTHERS: 01), 22 April 1986, * abstract * | 1-7,9-14 | |
| X | WO 89 10028 A (PHILIPS NV) 19 October 1989 * page 6, line 9 - page 10, line 25; figures 2,3 * | 1-7,9-14 | |
| X | US 3 548 319 A (PRICE WILLIAM L) 15 December 1970 * figures 5,6 * | 1-7,9-14 | TECHNICAL FIELDS SEARCHED (Int.Cl.6) H03K |
| A | PATENT ABSTRACTS OF JAPAN vol. 015, no. 299 (E-1095), 30 July 1991 & JP 03 106223 A (NEC CORP), 2 May 1991, * abstract * | 1,5 | |

The present search report has been drawn up for all claims

| Place of search | Date of completion of the search | Examiner |
|---|---|---|
| THE HAGUE | 16 July 1997 | Feuer, F |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)